# EUROPEAN PATENT APPLICATION

(11) **EP 1 821 332 A1**
(43) Date of publication of application: **22.08.2007**
(21) Application number: 07102501.9
(22) Date of filing: 15.02.2007
(51) Int. Cl.: H01J 37/32

(54) **A non-polluting material coating device**

(30) Priority: 16.02.2006 IT AT20060002
(71) Applicant: iGUZZINI ILLUMINAZIONE S.p.A., 62019 Recanati-Macerata (IT)
(72) Inventor: Garzino-Demo, Giovanni, 14054, Castagnole delle Lanze (Asti) (IT)
(74) Representative: De Gregori, Antonella

(57) **Abstract**

The present invention relates to a non-polluting device developed with the aim of generating and accelerating ions for carrying out non-polluting depositions (PVD) on both metallic and insulating substrates, and for use in high energy ion accelerators by means of the use of a cathodic arc.

The device for coating materials according to the present invention comprises a cathodic arc source essentially constituted by a cathode (1) and an anode (2) capable of generating a cathodic arc between them for the production of ion plasma, which is characterized in that the arc source is associated with an electrical or electromagnetic lens (3, 5, 6, 6' , 6", 7) for directing the ion plasma in a predetermined direction.

## Description

This invention relates to a non-polluting device developed with the aim of generating and accelerating ions for carrying out non-polluting depositions (PVD) on both metallic and insulating substrates, and for use in high energy ion accelerators by means of the use of a cathodic arc.

Cathodic arc sources are well known in the scientific literature, for example in the book "Thin film processes II", edited by John Vossen and Werner Kern and written by Philip C. Johnson (pp. 209-280), published by Academic Press (ISBN 0-12-728251-3).

These types of sources generate a very dense ion plasma beam and are used for example for PVD (Physical Vapour Deposition) coating of metallic substrates, such as for example machine tools, moulds and such like. Since the system is non-directional, in the meaning that the ions scatter in all directions, with the aim of directing the ions towards the substrates to be coated, said substrates, which are insulated from the metallic structure of the machinery, are connected to a negative voltage of several kilovolts, so as to attract the positively charged ions towards them; but this effect cannot be achieved if the materials to be coated are insulators.

One further application of this device finds use in high energy ion accelerators for the implantation of ions inside substrates, with the aim of improving the technical characteristics, such as resistance to wear or oxidation, or in order to make the surfaces auto-lubricating or for other applications.

A further advantage of this device is provided by being able to neutralize the ions after their acceleration, with the possibility of them being able to coat plastic materials, which are not capable of supporting the high temperatures of the incoming ions.

Further advantages will become evident from the description and the claims.

The characteristics and advantages of a device for coating materials according to the present invention will become clearer from the following exemplifying and non-limiting description which refers to the following schematic diagrams wherein:
- Fig. 1 is a first embodiment of the device according to the invention;
- Fig. 2 is a second embodiment of the device according to the invention;
- Fig. 3 is a third embodiment of the device according to the invention.

A detailed description of the various devices is provided below.

In all the figures shown, the sources may be made with circular, square, rectangular or other shaped cross sections, without altering the validity of the invention.

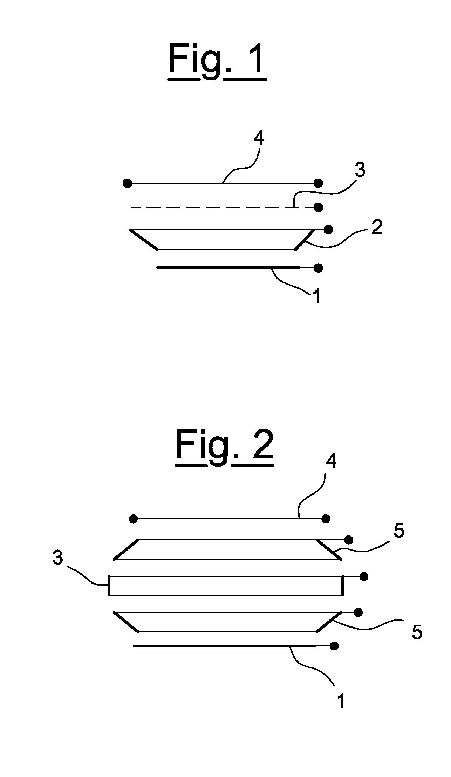

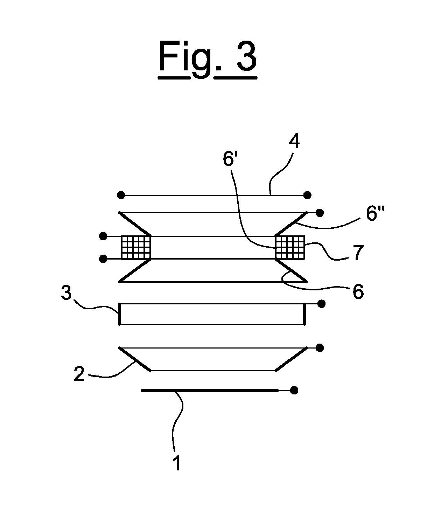

In Fig. 1 the number 1 indicates the cathode, which is supplied by an electrical voltage of between -10 and - 30 Volts depending on the material (metal) from which it is made. The lower part of said cathode is water-cooled, but for clearer understanding of the drawings, the cooling circuit has been omitted since it is irrelevant to the definition of the scope of protection of the invention. The number 2 indicates the anode, which is connected to the positive pole of the cathode power supply, the positive pole of which is simultaneously connected to the metallic structure of the equipment, which is in turn connected to earth. The cathode 1 and the anode 2 are common to figures 2 and 3. In some cases a magnetic circuit may be attached to the cathode, according to a different embodiment, with the aim of accelerating the process without altering the scope of protection of the invention.

The essential element of the invention is constituted by an additional electrode, denominated accelerator, indicated by 3, which can be constituted by a grille, as shown in Fig. 1, or by a sheet, shaped in various ways, as shown in Figs. 2 and 3.

An additional element, which can improve the ion flow is constituted by an electrode, denominated the focuser, which is missing in Fig. 1, represented by 5 in Fig. 2 and can be realized for example by a sheet shaped in various ways, even different from that shown in Fig. 2, without departing from the scope of protection of the invention.

The focusing electrode 5 can also be substituted by a magnetic focuser, as shown in Fig. 3, where the polar expansions are schematically represented by 6, 6' and 6" and the magnetizing coil by 7.

In any case, the anode 2, the accelerator 3 and respectively the focusing electrode 5 or the magnetic focuser 6, 6', 6", 7 constitute an electrical lens unit, well known in the scientific literature, and which can also be made in a different manner from those represented herein without departing from the scope of protection of the invention.

The accelerator electrode 3 is generally supplied at a voltage comprised of between -10 and -1000 V, depending on the acceleration it is desired to impart to the ions, by means of a stabilized power supply, the positive pole of which is connected to earth. Voltage to the focuser is supplied by an additional stabilized power supply, and can vary between 0 and 100 V; again in this case the negative pole is connected to earth.

In the case of electromagnetic focusing, the current supplied to the coil 7 depends on the number of turns and the diameter of the wire used, according to well known calculations, and said current must be capable of varying between 0 and 100% in order to be able to adjust the focusing of the ion beam.

One further advantage of the device described is represented by the possibility of being able to use a neutralizing electrode, represented by 4 in figures 1, 2 and 3, constituted by a filament which can become incandescent, so as to make it capable of emitting a significant quantity of electrons, which by being negatively charged, are capable of neutralizing the ions.

This neutralizing process allows the coating of plastic materials which are not capable of supporting the high temperatures of the incoming ions.

### FIRST OPERATIONAL EXAMPLE

The first operational example describes the essential elements for the validity of the invention. With reference to Fig. 1, 1 represents the cathode constituted by the material (metal) used to generate the ions. Said cathode may have a circular, square, rectangular or any other shaped cross-section, without departing from the scope of protection of the invention, and is constituted by a metal plate, at least several millimeters thick, which is water cooled in the lower part of the figure. Not being essential for the definition of the scope of protection of the invention, and for greater understanding of the device, said cooling system has been omitted.

There are examples of arc cathodes in the scientific literature, and any embodiment is suitable for being used in the described device, without departing from the scope of protection of the invention, hence the cathode 1 is represented schematically. The cathode is electrically connected to the negative pole of a direct current (DC) stabilized power supply, the voltage of which varies between -10 and -30 V, depending on the material (metal) with which it is made.

The number 2 indicates the anode, which can have a truncated cone, cylindrical, square, rectangular and any other shape, without departing from the scope of protection of the invention. The anode 2 is connected to the positive pole of the power supply to which the cathode is connected, and furthermore, at the same time, said positive pole is connected to the metallic structure of its housing, which is in turn connected to earth.

The number 3 indicates an additional electrode known as the accelerator. This electrode may be realized as the anode, in one of the embodiments described, or, as shown in the figure, by a grille. The combined cathode 2 and accelerator 3 group constitutes an electrical lens having two electrodes, which is capable of accelerating ions in the opposite direction to that of the cathode, according to the axis of said electrical lens.

In the arc sources manufactured to date, the directionality of the ions is obtained by providing a negative voltage to the metal substrates to be coated, for example machine tools, moulds and such like, but this is not possible if the substrates are insulators, while this is made possible by the electrical lens inserted downstream of the cathode.

The accelerator electrode is connected to the negative pole of a second stabilized power supply, the voltage of which can be made to vary between -10 and -1,000 V., depending on the acceleration it is desired to impart to the ions. The positive pole of said power supply is connected to earth.

The number 4 indicates the neutralizer electrode constituted by a filament, which when necessary is supplied by several volts, depending on the section and length of the wire (for example, made of tungsten), so as to make it incandescent.

It is well known that an incandescent filament is capable of emitting a large quantity of electrons; in this case the electrons are capable of neutralizing the incoming ions, thus allowing the coating of plastic materials which are not capable of supporting the high temperatures of the ions.

One pole of the filament power supply is connected to earth.

### SECOND OPERATIONAL EXAMPLE

In the second operational example, besides the components described in the first example, in Fig. 2 the number 5 indicates an additional electrode, denominated focuser, with the purpose of further concentrating the ion beam towards the substrates to be coated. In this figure, the number 1 represents the cathode, 2 the anode, 3 the accelerator and 4 the neutralizer, for which the details already described in the first example also hold, including the values relating to the electrical supplies.

The focusing electrode 5 is connected to the positive pole of a stabilized power supply, capable of supplying voltages of between 0 and 100 V, and having the negative pole connected to earth.

The group consisting of the anode 2, accelerator 3 and the focuser 5 make up a three electrode electrical lens, and can have various forms, as described in the scientific literature, without departing from the scope of protection of the invention. In relation to electrode geometry, all the points already mentioned in the first example are still valid.

### THIRD OPERATIONAL EXAMPLE

With reference to Fig. 3, the number 1 indicates the cathode, 2 the anode, 3 the accelerator electrode and 4 the neutralizer, with all the comments made in the first two examples still applying.

In this third example, the focusing electrode is realized by means of an electromagnetic lens.

In said Fig. 3 the numbers 6, 6' and 6" represent one of the possible magnetic profiles of the lens and 7 the electrical coil for its magnetization, by means of a DC power supply. Said coil is designed according to well known principles, and the related current must be allowed to vary between 0 and 100% by means of the stabilized power supply. The magnetic profile is not binding and can be formed in the most appropriate manner without altering the validity of the invention.

## Claims

1. A device for coating materials comprising a cathodic arc source essentially constituted by a cathode (1) and an anode (2) capable of generating a cathodic arc between them for the production of ion plasma, **characterized in that** said arc source is associated with an electrical or electromagnetic lens (3, 5, 6, 6' , 6" , 7) for directing said ion plasma in a predetermined direction.

2. The device according to claim 1 **characterized in that** said electrical or electromagnetic lens comprises at least one accelerator electrode (3) capable of accelerating the ions present in said ion plasma.

3. The device according to claims 1 or 2 **characterized in** further comprising a neutralizing electrode (4) for neutralizing said ions of said ion plasma.

4. The device according to one of the preceding claims **characterized in that** said cathode (1) of said cathodic arc source is connected to a stabilized direct current power supply, at a voltage comprised of between -10V and -30V.

5. The device according to claim 4 **characterized in that** said anode (2) of said cathodic arc source is connected to the positive pole of said power supply, and at the same time the metallic structure of a machinery containing it.

6. The device according to claim 5 **characterized in that** said machinery comprises a closed container, inside of which is produced a pressure of less than 0.10 Pa.

7. The device according to claim 5 **characterized in that** said pressure in said container is produced by means of air expulsion pumps.

8. The device according to any of the claims 2 to 7 **characterized in that** said accelerator electrode (3) is supplied at a continuous voltage of between -10 and -1000 V depending on the speed to be imparted to said ions.

9. The device according to any of the claims 2 to 8 **characterized in that** said accelerator electrode (3) is configured as a grille.

10. The device according to any of the claims 2 to 8 **characterized in that** said accelerator electrode (3) is constituted by a metal shape suited to producing said acceleration of said ions.

11. The device according to any of the claims 3 to 10 **characterized in that** said neutralizing electrode (4) is constituted by a filament capable of emitting electrons for neutralizing said accelerated ions.

12. The device according to any of the claims 2 to 11 **characterized in that** said electrical lens further comprises at least one focusing electrode (5) suitable for concentrating the accelerated ions from said accelerator electrode (3).

13. The device according to claim 12 **characterized in that** said focusing electrode (5) is supplied by a DC voltage that can be adjusted between 0 and 100 V.

14. The device according to any of the claims 2 to 11 **characterized in that** said electromagnetic lens further comprises a magnetic core (6,6',6") and an electrical coil (7) suitable for magnetizing said magnetic core (6,6',6") by means of an electrical current supplied by a stabilized power supply with 0-100% adjustment.

15. The device according to claim 14 wherein the value of said electrical current depends on the number of turns and the thickness of the wire used.
